# EUROPEAN PATENT SPECIFICATION

(11) **EP 4 480 737 B1**
(45) Date of publication and mention of the grant of the patent: **15.04.2026**
(21) Application number: 23180975.7
(22) Date of filing: 22.06.2023
(51) Int. Cl.: B60L 53/10, B60L 53/16, B60L 53/18, B60L 53/30, H01B 9/00, H01R 13/03, H01R 13/658, H01R 13/6592, H01R 24/30, H01R 31/06

(54) **DC CHARGING CABLE ASSEMBLY FOR CHARGING AN ELECTRICAL VEHICLE, DC CHARGING SYSTEM FOR CHARGING AN ELECTRICAL VEHICLE AND METHOD FOR CHARGING AN ELECTRICAL VEHICLE**
GLEICHSTROMLADEKABELANORDNUNG ZUM LADEN EINES ELEKTROFAHRZEUGS, GLEICHSTROMLADESYSTEM ZUM LADEN EINES ELEKTROFAHRZEUGS UND VERFAHREN ZUM LADEN EINES ELEKTROFAHRZEUGS
ENSEMBLE CÂBLE DE CHARGE CC POUR CHARGER UN VÉHICULE ÉLECTRIQUE, SYSTÈME DE CHARGE CC POUR CHARGER UN VÉHICULE ÉLECTRIQUE ET PROCÉDÉ POUR CHARGER UN VÉHICULE ÉLECTRIQUE

(43) Date of publication of application: 25.12.2024
(73) Proprietor: ABB E-mobility B.V., 2629 JG Delft (NL)
(72) Inventor: BAHMANI, Amin, 5018 Erlinsbach (CH); GARCIA-FERRE, Francisco, 5400 Baden (CH); KHEIRI, Pedram, 4332 Stein (CH)
(74) Representative: Zimmermann & Partner Patentanwälte mbB

(56) References cited:
- DE-U1- 202019 105 511
- US-A1- 2022 144 111
- US-A1- 2022 144 115
- US-A1- 2023 035 457
- US-A1- 2023 136 576
- US-B2- 10 894 479

## Description

### TECHNICAL FIELD

Embodiments of the present disclosure relate to a DC charging cable assembly for charging an electrical vehicle. Further embodiments of the present disclosure relate to a DC charging system for charging an electrical vehicle and a method for charging an electrical vehicle.

### BACKGROUND

When it comes to power lines or electrical devices, electromagnetic radiation and its potential risks are often a topic of discussion. Exposure limits are in place to protect humans from adverse health impacts.

When current is flowing through a wire, a magnetic field is created in addition to the electric field. Magnetic fields penetrate most matter more easily than electric fields. The strength of the magnetic field is dependent on the magnitude of the current flowing through the wire. Magnetic fields are also created by direct currents, as used in various electronic consumer goods. The lower the current intensity on a line, the lower the magnetic field around the cable.

Power ratings and consequently the current rating of charging cables is increasing constantly to meet the fast-growing demands of e-mobility business. The current ratings can increase up to 1 kA, up to 2 kA and even up to 3 kA. Therefore, it is important to consider the stray magnetic field around the cable. In addition to the health limits outlined by ICNIRP, there are limits for electromagnetic compatibility and potentially susceptible devices such as medical implants known as active implantable medical devices (AIMD). The occupational EMF Directive 2013/35/EU specifies that static magnetic fields should be less than 500 micro Tesla. US 2022/0144115 A1 describes a system and method for a liquid cooled cable arrangement for high-power fast charging of electric vehicles that includes a charging connector and a liquid cooled charging cable. DE 20 2019 105 511 U1 describes an electric vehicle charging system for charging an electric vehicle. US 10 894 479 B2 describes a charging cable device for a fast charging station for fast charging a battery of a vehicle with an electric drive, having a temperature control device, and a charging cable connected thereto. US 2023/136576 A1 discloses DC charging cable assembly for charging an electrical vehicle, the charging cable assembly comprising: a cable, comprising:a first-polarity; second-polarity conductor; and a magnetic shielding, wherein the magnetic shielding is provided by a dispersion of magnetic shielding material provided in an external polymeric insulation of the cable, according to the state of the art.

Accordingly, in view of the above, there is a demand for an improved DC charging cable assembly, DC charging system and method of charging an electrical vehicle which at least partially overcome the problems of the state of the art.

### SUMMARY

In light of the above, a DC charging cable assembly, a DC charging system and a method of charging an electric vehicle according to the independent claims are provided. Further aspects, advantages, and features are apparent from the dependent claims, the description, and the accompanying drawings.

According to an aspect of the present disclosure, a DC charging cable assembly for charging an electrical vehicle is provided. The charging cable assembly includes a cable, including a plurality of first-polarity conductors, a plurality of second-polarity conductors, and a magnetic shielding, wherein the magnetic shielding is provided by a dispersion of magnetic shielding material provided in an external polymeric insulation of the cable. In a cross-section of the cable, the first-polarity conductors and the second-polarity conductors are arranged circumferentially in an interleaved arrangement. The magnetic shielding radially surrounds the interleaved arrangement of the first-polarity conductors and the second-polarity conductors. The charging cable assembly includes a first connector at a first end of the cable configured to connect the cable to a power source, the connector being configured for connecting the first-polarity conductors to a first-polarity voltage and connecting the second-polarity conductors to a second-polarity voltage.

According to a further aspect, a DC charging system for charging an electrical vehicle is provided. The charging system includes a DC charging cable assembly according to aspects of the present disclosure and a charging station body. The charging station body comprises a power source configured to provide the first-polarity voltage and the second-polarity voltage, the power source being connected to the first connector of the DC charging cable assembly.

A method of charging an electrical vehicle with a DC charging cable assembly according to aspects of the present disclosure. The method includes applying a first-polarity voltage to the first-polarity conductors, applying a second polarity voltage to the second-polarity conductors, and charging the electrical vehicle.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
Fig. 1 shows a schematic sectional view of a cable according to embodiments described herein
Fig. 2 shows a schematic view of a charging cable assembly according to embodiments described herein
Fig. 3A shows a schematic sectional view of a cable according to embodiments described herein
Fig. 3B shows a schematic sectional view of a cable according to embodiments described herein
Fig. 3C shows a schematic sectional view of a cable according to embodiments described herein
Fig. 4 shows a schematic view of a charging system according to embodiments described herein
Fig. 5 shows a flow diagram illustrating a method of charging an electric vehicle according to embodiments described herein

### DETAILED DESCRIPTION OF EMBODIMENTS

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations.

Within the following description of the drawings, the same reference numbers refer to the same or to similar components. Generally, only the differences with respect to the individual embodiments are described. Unless specified otherwise, the description of a part or aspect in one embodiment can apply to a corresponding part or aspect in another embodiment as well.

It is desired to allow for increased current ratings of a charging cable, for example a charging cable for electrical vehicles, of up to 1 kA, 2 kA and even up to 3 kA without undue increase in the magnetic fields. For example, the occupational EMF Directive 2013/35/EU specifies that static magnetic fields should be less than 500 micro Tesla, which can be challenging to achieve when currents of 1kA or higher are applied.

Advantageously, according to the present disclosure, the magnetic field outside of a cable can be suppressed by a synergistic combination of magnetic shielding and interleaved arrangement of conductors of different polarities.

First, the magnetic shielding is described in more detail.

The shielding may be a mu-metal shielding, i.e. the cable having magnetic shielding. The shielding is preferably a common shielding surrounding all the conductors of the cable. Mu-metal is a soft magnetic alloy with exceptionally high magnetic permeability. The high permeability of mu-metal provides a low reluctance path for magnetic flux, leading to its use in magnetic shields against static or slowly varying magnetic fields. Magnetic shielding made with high-permeability alloys like mu-metal works by providing a path for the magnetic field lines around the shielded area. Thus, an effective shape for the shield is a (in cross-sectional view) closed-loop shape surrounding the shielded space. The effectiveness of mu-metal shielding is correlated with the alloy's permeability, which drops off at both low field strengths and, due to saturation, at high field strengths.

The present disclosure further proposes interleaving conductors of different polarities. For example, for a cable having six conductors, instead of three plus conductors in one side and three minus conductors on the other side, the conductors can be arranged in a +-+-+- arrangement, i.e. an interleaved arrangement. Interleaving conductors of different polarities allows to suppress the magnetic field by another mechanism than the addition of a magnetic shielding, and without the increase of weight and stiffness that may result from a magnetic shielding layer.

The present disclosure proposes a hybrid solution. The hybrid solution is the combination of interleaving conductors of different polarities and the magnetic shield to provide an improved suppression of a magnetic field. The magnetic shield surrounds the interleaved arrangement of the conductors and thus an arrangement that already suppresses the magnetic field. As the magnetic field is already suppressed by the interleaved conductors, the demands on the magnetic shield are reduced, allowing for example the magnetic shield to be designed thinner and lighter than may otherwise be required. Furthermore, the magnetic shield, shielding only an already-suppressed field, may work in a non-saturated state and therefore particularly efficiently, even for high currents.

### General description of further aspects of the invention

Next, some further possible aspects of the present disclosure are described, which can freely be combined with one another unless specified otherwise. According to an aspect of the present disclosure, a DC charging cable assembly for charging an electrical vehicle is provided. The charging cable assembly includes a cable, including a plurality of first-polarity conductors, a plurality of second-polarity conductors, and a magnetic shielding. In a cross-section of the cable, the first-polarity conductors and the second-polarity conductors are arranged circumferentially in an interleaved arrangement. The magnetic shielding radially surrounds the interleaved arrangement of the first-polarity conductors and the second-polarity conductors. The charging cable assembly includes a first connector at a first end of the cable configured to connect the cable to a power source, the connector being configured for connecting the first-polarity conductors to a first-polarity voltage and connecting the second-polarity conductors to a second-polarity voltage. Thereby, it may be defined by the connector which conductors are first-polarity conductors and which ones are second-polarity conductors.

The cable may extend along a first dimension corresponding to an extended direction of the cable. The cable may extend from a first end of the cable to a second end of the cable. The plurality of first polarity conductors may extend along the extended direction of the cable, in particular from the first end of the cable to the second end of the cable. The plurality of second-polarity conductors may extend along the extended direction of the cable, in particular from the first end of the cable to the second end of the cable.. The cable may extend at least 1 m along the extended direction of the cable. The plurality of first- and/or second-polarity conductors may thus also extend at least 1 m along the extended direction of the cable. The cable may further comprise a ground conductor. The ground conductor may extend along the extended direction of the cable.

The cross-section of the cable may be substantially perpendicular to the first dimension. The cross-sectional shape of the cable may be substantially circular. Throughout this description, the arrangement of the conductors within the cable is described within the cross-section, preferably within any cross-section along the cable. The cable may extend along the extended direction of the cable without changing of the arrangement of the conductors within the cross-section. In one embodiment, the first-polarity conductors and the second-polarity conductors (and optionally the at least one ground conductor) extend parallel to the extended direction of the cable. Particularly, the conductors are not twirled along the extended direction of the cable. The cable may extend along the extended direction of the cable and the conductors might be twirled around a geometrical center of the cable. Cross-sections of a cable with twirled conductors, which are taken at different location along the extended direction of the cable, only differ from each other by a rotation.

The cable comprises a plurality of first-polarity conductors and a plurality of second-polarity conductors. The plurality of first-polarity conductors, the plurality of second polarity conductors and, if present, the ground conductor will be jointly referred to as the conductors. The plurality of first-polarity conductors and the plurality of second-polarity conductors may be arranged circumferentially around the geometrical center of the cable. The conductors may be separated from each other by a (dielectric) filler material. The first-polarity conductors and the second-polarity conductors may be provided in parallel.

The plurality of first-polarity conductors and the plurality of second-polarity conductors may be arranged in an interleaved arrangement. Throughout this description, an interleaved arrangement of the first-polarity conductors and the plurality of second-polarity conductors refers to an arrangement, in which the first-polarity conductors and the second polarity conductors are arranged alternatingly. Particularly, first-polarity conductors have second-polarity conductors as neighbors and second-polarity conductors have first-polarity conductors as neighbors. This does not exclude one or more optional ground conductors, which are not considered in this definition, to be arranged in-between conductors of different polarity.

The conductors may be arranged circumferentially around a geometrical center of a cable, i.e. an circumferential arrangement. Particularly, the first-polarity conductors and the second polarity conductors may be arranged along a single circumferential line, along which the plurality of first-polarity conductors and the plurality of second polarity conductors are arranged alternatingly.

The DC charging cable assembly includes a first connector at the first end of the cable to connect the cable to a power source. The power source may include a first outlet, the first outlet providing a first-polarity voltage. The power source may include a second outlet, the second outlet providing a second-polarity voltage. The connector may be configured for connecting the first-polarity conductors to a first outlet of the power source providing a first-polarity voltage. The connector is configured for connecting the second-polarity conductors to a second outlet of the power source providing a second-polarity voltage. The connector may galvanically connect the first-polarity conductors to the power source, particularly galvanically connect the first-polarity conductors to the first outlet of the power source providing the first-polarity voltage. The connector may galvanically connect the second-polarity conductors to the power source, particularly galvanically connect the second-polarity conductors to the second outlet of the power source providing the second-polarity voltage.

The first- and second-polarity voltages are of opposite polarities. Thus, the first-polarity voltage may be a positive voltage and the second-polarity voltage may be a negative voltage. Alternatively, the first-polarity voltage may be a negative voltage and the second-polarity voltage may be a positive voltage.

The cable may be configured for supporting high currents, particularly for supporting currents up to 3 kA. The cable may be a megawatt (MW) charging cable configured for providing a power of more than 1 MW during charging.

According to an embodiment, which can be combined with other embodiments described herein, the DC charging cable assembly includes a first ground conductor, wherein: the first ground conductor extends from the first end of the cable to the second end of the cable. The first ground conductor may extend along the extend direction of the cable. The DC charging cable assembly may further include a second ground conductor, wherein the second ground conductor extends from the first end of the cable to the second of the cable. The second ground conductor may extend along the extended direction of the cable. The first ground conductor and the second ground conductor may be (galvanically) connected to each other at at least one of the first end of the cable and the second of the cable. In particular, the ground conductor may be splitted between the first end of the cable and the second end of the cable.

In embodiments having the first ground conductor and the second ground conductor, the cross-sectional area of each of the first ground conductor and the second ground conductor can be reduced compared to the cross-sectional area of the ground conductor in an embodiment having only the first ground conductor. The first ground conductor can be placed between a first-polarity conductor and a second-polarity conductor. The second ground conductor can be placed between a first-polarity conductor and a second-polarity conductor. The first ground conductor and the second ground conductor can be placed diametrically opposite from each other in the circumferential arrangement. The cable may have a 2-fold rotational symmetry and rotation of the cable of 180° around an axis perpendicular to the cross-section will result in the same cross-sectional shape. In cables having interleaved conductors, the symmetric arrangement of the cable may improve the suppression of the magnetic field outside of the cable. The FEM simulation result shows a reduction in the critical distances in which the magnetic fields are violated in the range of 5 - 10%, i.e. reduction in the critical distance is in the range of 5 - 10%. This effect can be combined with other effects for suppressing the magnetic fields, such as the magnetic shielding, the interleaving of conductors of different polarities and the hybrid solution, to further suppress the magnetic field.

According to an embodiment, which can be combined with other embodiments described herein, the first-polarity conductors and/or the second-polarity conductors have a circular or oval, preferably elliptical cross-sectional shape. Preferably, all first-polarity conductors and/or second-polarity conductors have the same cross-sectional shape. For example, a cable can have one, more or all of the first-polarity and/or second-polarity conductors with an elliptical cross-sectional shape with, e.g., the major axis in radial direction and the minor axis in circumferential direction or with the major axis in circumferential direction and the minor axis in radial direction. This arrangement turns out to be effective for further suppressing the magnetic fields.

According to an embodiment, which can be combined with other embodiments described herein, the first-polarity conductors and the second-polarity conductors have a cross sectional shape of a rectangle with curved edges or a cross sectional shape of a rectangle with flattened edges. For example, a cable can have three first-polarity conductors having cross sectional shape of a rectangle with flattened edges and three second-polarity conductors having cross-sectional shape of a rectangle with flattened edges. This arrangement turns out to be effective for allowing a high density of conducting material without increasing the magnetic fields.

The number of conductors, in particular the number of first-polarity conductors and the number of second-polarity conductors may be changed. For example, the cable may have 2, 3 or 4 first-polarity conductors and a corresponding 2, 3 or 4 second-polarity conductors. Generally, the total number of first-polarity conductors and the number of second-polarity conductors is even and at least 4 (i.e., at least 2 first-polarity conductors and at least 2 second-polarity conductors). Beneficially, the cable has the same number of first-polarity conductors and second-polarity conductors. When increasing the number of conductors and applying interleaving at the same time, the magnetic field is distributed more homogenously around the cable, thereby further reducing the critical distances.

According to an embodiment, which can be combined with other embodiments described herein the DC charging cable assembly includes, for each of the first-polarity conductor and each of the second-polarity conductor, a dielectric insulation surrounding the respective conductor, wherein the dielectric insulation has a breakdown strength of at least 1 kV/mm. The dielectric insulation may be the same for each of the first-polarity conductor and each of the second-polarity conductor. In particular, the dielectric insulation may have the same strength for each of the first polarity conductor and each of the second-polarity conductor. The dielectric insulation may radially surround the respective conductor. The dielectric insulation may extend along the extended direction of the cable.

The cables have an interleaved arrangement of first-polarity conductors and second-polarity conductors. A first-polarity voltage is applied to the first-polarity conductors and a second polarity voltage is applied to the second-polarity conductors. The first-polarity voltage and the second-polarity voltage have opposite polarity. In the interleaved arrangement, the first-polarity conductors have second-polarity conductors as next neighbors and vice versa, i.e. always opposite polarity conductors are neighboring each other. In the previously known high current charging cables not belonging to the invention, same-polarity conductors are neighboring each other. For example, negative polarity conductors are on one side and positive polarity conductors are on the other side of the cable cross-section. There was a technical prejudice that a separation of polarities should be kept in order to reduce electrical fields within the cable and to correspondingly reduce dielectric insulation requirements, whereas the magnetic field requirements were not considered. For cables according to the invention, having interleaved arrangement of first-polarity conductors and second-polarity conductors, the conductors may be provided with sufficiently high dielectric insulation to prevent electrical breakthrough between first-polarity conductor and second-polarity conductor when the first-polarity voltage is provided to the first-polarity conductor and the second-polarity voltage is provided to the second-polarity conductor.

According to an embodiment, which can be combined with other embodiments described herein, the dielectric insulation has a minimal thickness between neighboring conductors of at least 0.1 mm.

The magnetic shielding can be formed from mu-metal (µ-metal). Particularly, the magnetic shielding can be formed of a foil, in particular a homogenous and/or solid foil radially surrounding the conductors. Also a non-solid shielding is possible such as a mesh-like layer radially surrounding the conductors. Preferably the shielding provides a continuously connected path circumferentially around the cable.

The magnetic shielding may be made of metal, in particular mu-metal. Mu-metal is a nickel-iron soft magnetic alloy with very high permeability. For example, the Ni content may be at least 75 mass%, the Fe content may be at least 10 mass%, the total Ni+Fe content may be at least 85 or even 90 mass% and/or at most 98 or 95 mass%. In a first example composition, Mu-metal has approximately 77% nickel, 16% iron, 5% copper, and 2% chromium or molybdenum. In another example composition, mu-metal is ASTM A753 and is composed of approximately 80% nickel, 5% molybdenum, small amounts of various other elements such as silicon, and 12 ~ 15% iron for the remainder. The magnetic shielding can be made of other materials having similar magnetic properties as mu-metal. The other materials having similar magnetic properties as mu-metal are, for example, Co-Netic, supermalloy, supermumetal, nilomag, sanbold, molybdenum permalloy, Sendust, M-1040, Hipernom, HyMu-80 and Amumetal. Further, the magnetic shielding can be made of ceramic ferrite.

Applying the magnetic shielding as a solid sheet allows for efficient fabrication. According to an embodiment, which can be combined with other embodiments described herein, the magnetic shielding is made of µ-metal and has a thickness of 0.05 mm to 2 mm, particularly a thickness of 0.05 mm to 1 mm. For example, a thickness of at least 0.05 mm, preferably at least 0.1 mm, and particularly preferably at least 0.2 mm is advantageous. On the other hand, the magnetic shielding layer should be not too thick in order to allow compactness and avoid stiffness of the cable. Hence, a thickness of at most 1 mm, preferably at most 0.5 mm or even at most 0.3 mm is preferred.

According to the invention, which can be combined with other embodiments described herein, the magnetic shielding is provided by a dispersion of magnetic shielding material provided in an external polymeric insulation of the cable. A magnetic shielding provided as a dispersion has less impact on the mechanical properties of the cable. Cables, for which magnetic shielding is provided as a dispersion, can be lighter and more flexible compared to cables having a bulk magnetic shielding.

In the cable according to embodiments described herein, a hybrid solution is implemented. Herein, a hybrid solution refers to a cable in which the first-polarity conductors and the second-polarity conductors are arranged in an interleaved arrangement and a magnetic shielding radially surrounds the interleaved arrangement. As described above, the suppression of the magnetic field by the interleaved arrangement and the magnetic shielding synergistically influence each other to provide an improved suppression of the magnetic field, i.e. reduction of the critical distance. Moreover, the hybrid solution can be provided with a significantly thinner magnetic shielding as compared to solutions only provided with a magnetic shielding while simultaneously providing a higher suppression of the magnetic field. Compared to a magnetic shielding of a cable only provided with magnetic shielding, the magnetic shield in the hybrid solution can be 80% or more lighter, while the cable with hybrid solution simultaneously provides a higher suppression of the magnetic field compared to the cable only having magnetic shielding. Beneficially, cables having the hybrid solution have improved suppression of the magnetic field, less weight and are more flexible as, for example, cables provided with a magnetic shielding.

According to an embodiment, which can be combined with other embodiments described herein, the DC charging cable assembly includes a second connector at a second end of the cable configured to connect the cable to an electrical vehicle for charging the electrical vehicle. The second connector may be configured to connect the conductors of the cable to the corresponding contacts of the electrical vehicle. The second connector may be configured to connect the first-polarity conductors to first-polarity contacts of the electrical vehicle. The second connector may be configured to connect the second-polarity conductors to second-polarity contacts of the electrical vehicle. The second connector may be configured to connect the ground conductor to a ground contact of the electrical vehicle.

The first connector may be connected to a power source to connect the cable of the DC charging cable assembly to the power source. The first-polarity conductors may be connected to a first-polarity voltage provided by the power source. The second-polarity conductors may be connected to a second-polarity voltage provided by the power source. The ground conductor may be connected to a ground contact of the power source. The second connector may be connected to an electrical vehicle to connect the cable of the DC charging cable assembly to the electrical vehicle. The first-polarity conductors may be connected to first-polarity contacts of the electrical vehicle. The second-polarity conductors may be connected to second-polarity contacts of the electrical vehicle. The ground conductor may be connected to a ground contact of the electrical vehicle. In this way, the first polarity voltage provided by the power source may be connected to the first-polarity contacts of the electrical vehicle. The second-polarity voltage may be connected to the second-polarity contacts of the electrical vehicle. The ground contact of the power source may be connected to the ground contact of the electrical vehicle. The electrical vehicle may be charged.

According to an aspect of the present application, a DC charging system for charging an electrical vehicle is provided. The charging system includes a DC charging cable assembly according to embodiments described herein and a charging station body. The charging station body comprises a power source configured to provide the first-polarity voltage and the second-polarity voltage, the power source being connected to the first connector of the DC charging cable assembly.

The charging station may comprise a user interface. The user interface may allow a user to set parameters for charging an electrical vehicle. The user may set charging duration, total charging energy, charging power, charging voltage and/or charging current and/or any other parameter for charging an electrical vehicle. The charging station may comprise a connection to an external power source. The charging station may comprise a grid connection. The power source may be connected to the grid. The charging station may comprise a connection to a renewable energy source. The renewable energy source may be any kind of renewable energy source. For example, the renewable energy source may be a photovoltaic energy source, a wind turbine, a geothermal energy source, a bioenergy energy source or a hydropower energy source. The power source may be connected to the renewable energy source. The charging station may comprise a battery module. The battery module may be configured to store energy. The battery module may be configured to be charged by the renewable energy source. The power source may be connected to the battery module.

According to an aspect of the present application, a method of charging an electrical vehicle with a DC charging cable assembly according to embodiments described herein is provided. The method includes applying a first-polarity voltage to the first-polarity conductors; applying a second polarity voltage to the second-polarity conductors; and charging the electrical vehicle.

According to an embodiment, the first-polarity voltage and the second-polarity voltage is provided by a charging station comprising a power source and the method includes: connecting the first-polarity conductors to a first outlet of the power source configured to provide a first-polarity voltage; and connecting the second-polarity conductors to a second outlet of the power source configured to provide a second-polarity voltage. The method may include galvanically connecting the first-polarity conductors to the first outlet of the power source. The method may include galvanically connecting the second-polarity conductor to a second outlet of the power source. The method may include connecting a ground conductor of the cable to a ground contact of the power source, particularly galvanically connecting the ground conductor to the ground contact of the power source. The connecting the first-polarity conductors to the first outlet of the power source may be facilitated by the first connector. The connecting the second-polarity conductors to the second outlet of the power source may be facilitated by the first connector. The connecting the ground conductor to the ground contact of the power source may be facilitated by the first connector.

According to an embodiment, the method includes connecting the cable to the electrical vehicle with a second connector, wherein: the second connector is provided at a second end of the cable, and the second connector is configured to connect the cable to an electrical vehicle for charging the electrical vehicle. The method may include connecting the first-polarity conductors to first-polarity contacts of the electric vehicle, particularly galvanically connecting the first-polarity conductors to the first-polarity contacts of the electric vehicle. The method may include connecting the second-polarity conductors to second-polarity contacts of the electric vehicle, particularly galvanically connecting the second-polarity conductors to the second-polarity contacts of the electrical vehicle. The method may include connecting the ground conductor to a ground contact of the electric vehicle, particularly galvanically connecting the ground conductor to the ground contact.

According to an embodiment, a rated voltage of the cable (rated DC voltage difference between the first-polarity voltage and the second-polarity voltage) is 0.2 - 2 kV, and/or a rated total current trough the plurality of first-polarity-conductors is 0.25 - 3 kA, particularly 1 - 3kA. According to an embodiment, a rated power of the cable is 0.4 - 5 MW.

### Comparative analysis

Next, a comparative analysis of an embodiment is discussed. In table 1 below, the critical distances for a number of cables is shown. The cables have six conductors and currents of 1 kA, 2 kA and 3 kA are applied. The critical distance defines the distance from the center of the cable below which the limit of 500 micro Tesla is exceeded. The values provided in table 1 are based on a finite-element (FEM) simulation.

**Table 1: Critical Distance values for a reference cable, a cable having magnetic shielding, a cable having interleaved polarities and a cable having a hybrid solution at currents of 1kA, 2kA and 3kA. The reference cable has a radius of 25 mm. The magnetic shielding of the cable with hybrid solution is five times lighter than the magnetic shielding of the cable having magnetic shielding.**

| Critical Distance | 1 kA | | 2 kA | | 3 kA | |
|---|---|---|---|---|---|---|
| Reference cable | 90 mm | 100% | 125 mm | 100% | 160 mm | 100% |
| Magnetic shielding | 25 mm | 27.7% | 92 mm | 73.6% | 129 mm | 80.6% |
| Interleaving | 39 mm | 43.3% | 46 mm | 36.8% | 55 mm | 34.4% |
| **Hybrid solution** | **23 mm** | **25.6%** | **28 mm** | **22.4%** | **32mm** | **20%** |

In table 1, the reference cable is a conventional high-current cable which is designed to carry up to 3kA and is used in DC charging applications. The reference cable has an radius of 25 mm. The reference cable has six non-interleaved conductors (arranged with + polarities at one side and - polarities at the other side), and no magnetic shielding. The remaining cables referred to in Table 1 are described in the following.

The "magnetic shielding" describes a cable not covered by the invention but useful for understanding the invention, which corresponds to the reference cable having, in addition, a 0.5 mm thick mu-metal shielding, but a non-interleaved arrangement of the conductors. As can be seen in table 1, the critical distances are reduced substantially and for the case of 1 kA fully suppressed outside of the extent of the cable.

The "interleaving" describes a cable not covered by the invention but useful for understanding the invention, which is a cable which corresponds to the reference cable having the conductors arranged in an interleaved manner but without magnetic shielding.

The hybrid solution is a cable according to an embodiment of the invention, with conductors arranged in an interleaved manner and surrounded by a magnetic shield. The hybrid solution is the same cable as the magnetic shielding, but has the conductors arranged in an interleaved manner and is provided with a thinner magnetic shielding with a thickness of the mu-metal shielding of 0.1 mm. The magnetic shielding of the "hybrid solution" cable has only about 20% of the weight of the 0.5 mm thick mu-metal shielding of the "magnetic shielding" cable. It is remarkable, that the hybrid cable performs consistently better than the Magnetic Shielding in spite of the thinner shielding while simultaneously having more advantageous mechanical properties such as bendability.

In table 1 above, the critical distance for a cable having magnetic shielding, interleaved conductors and the hybrid solution are compared to the critical distance of a reference cable.

As can be seen from table 1 above, the magnetic shielding provides an effective suppression of the magnetic field for lower current levels, i.e., at a current of 1kA, compared to the reference cable. For higher current levels such as 3kA, and consequently higher magnetic fields, the performance of the magnetic shielding is reduced compared to the reference cable.

In contrast, the suppression of the magnetic field for the cable having interleaved conductors increases with increasing current levels and is particularly effective at a current of 3kA.

Thus, the interleaved arrangement and the magnetic shielding have respective limitations for suppressing the magnetic field. In particular, magnetic shielding is best suited for lower current applications having lower magnetic field strength, e.g. up to current of 1kA, but become less effective for high currents. In contrast, interleaving the conductors of different polarities is best suited for higher currents having higher magnetic field strength, e.g. at currents of 3kA. Thereby, the interleaved arrangement and the magnetic shielding have an inverse dependency on current or field strength for suppressing the magnetic field, as indicated by the reduction in the critical distance. In the hybrid solution, these two approaches complement each other very well for achieving an effective shielding over a broad range of conditions.

The hybrid solution takes advantage of this inverse dependency of the magnetic shielding and the interleaved conductors on the magnetic field strength. The hybrid solution synergistically combines the magnetic shielding and the interleaved conductors to provide improved suppression of the magnetic field. In the hybrid solution, the cable is provided with interleaved conductors for different polarities and a magnetic shielding radially surrounding the cable is provided. The interleaved conductors suppress the magnetic field to lower field strength values, and therefore to a regime at which the magnetic shielding is particularly effective for suppressing the magnetic fields. Correspondingly, as can be seen in table 1, the hybrid solution provides the highest suppression of the magnetic field in all conditions.

This is possible although the magnetic shielding provided in the hybrid solution is 5 times lighter than the magnetic shielding provided in the cable having only the magnetic shielding. Advantageously, cables having hybrid solution can be provided with a thinner magnetic shielding while having improved suppression of the magnetic field. The cables having hybrid solution can therefore also be made more flexible and lighter while keeping an excellent magnetic shielding.

### Description of Figures

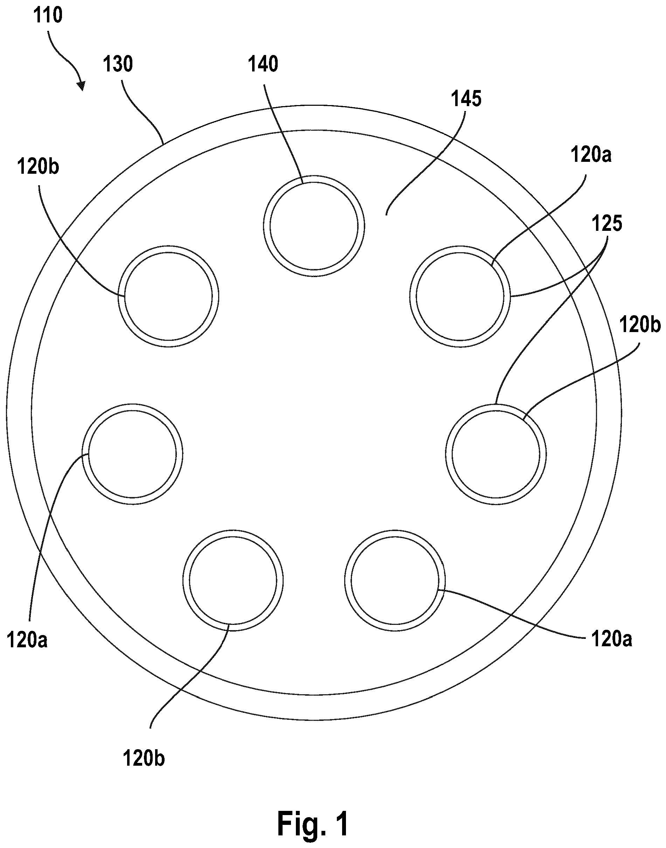

Fig. 1 shows a schematic sectional view of a cable 110 according to embodiments described herein. The cable comprises seven conductors which are arranged circumferentially around a geometrical center of the cable, i.e. arranged in a circumferential arrangement. The conductors are arranged in a single level having same distance to the geometrical center in the circumferential arrangement. The conductors are placed with equal angular distances to each other. The cable comprises a plurality of first-polarity conductors, a plurality of second-polarity conductors and a ground conductor. In the embodiment shown in Fig. 1, the cable comprises three first-polarity conductors 120a, three second-polarity conductors 120b and a ground conductor 140. The three first-polarity conductors 120a and the three second-polarity conductors 120b are arranged in an interleaved arrangement. First-polarity conductors 120a have second-polarity conductors 120b as next neighbors in the circumferential arrangement and second-polarity conductors 120b have first-polarity conductors 120a as next neighbors in the circumferential arrangement. The interleaved arrangement is subject to an exception for ground conductor. The ground conductor is placed between a first-polarity conductor and a second-polarity conductor in the circumferential arrangement. The three first-polarity conductors, the three second-polarity conductors and the ground conductor are provided with a dielectric insulation 125. The three first-polarity conductors, the three second-polarity conductors and the ground conductor are separated by a filler material 145. The cable has a magnetic shielding 130 radially surrounding the cable. It is understood that the cable extends into and out of the paper plane to form an elongated dimension, i.e. an extended direction of the cable.

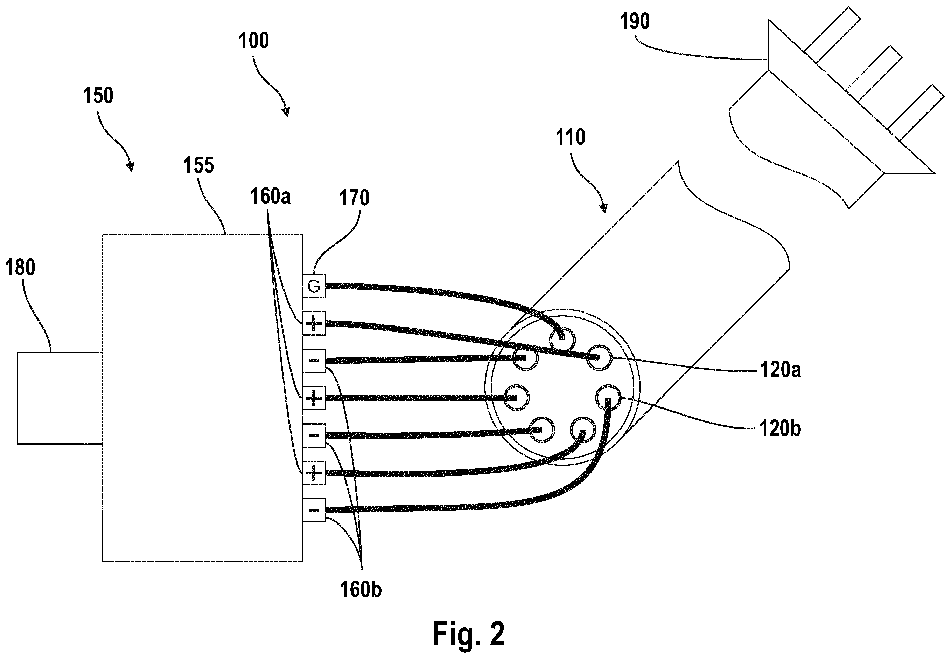

Fig. 2 shows a schematic view of a DC charging cable assembly 100 according to embodiments described herein. The charging cable assembly 100 comprises the cable 110 and a first connector 150. The first connector comprises a housing 155, a plurality of first-voltage outlets 160a, a plurality of second-voltage outlets 160b, a ground outlet 170 and an inlet 180. The first connector 150 comprises a first-voltage outlet 160a for each first-plurality conductor and a second-voltage outlet 160b for each second-plurality conductor. In the embodiment shown in Fig.2 the cable comprises three first-polarity conductors and three second-polarity conductors. The connector 150 comprises three first-voltage outlets 160a and three second-voltage outlets 160b. In Fig. 2 the first-voltage outlets 160a provide a positive voltage and the second-voltage outlets 160b provide a negative voltage. In other embodiments, the first-voltage outlets 160a can provide a negative voltage and the second-voltage outlets 160b can provide a positive voltage. Each of the first-voltage outlets 160a is connected to one of the first-polarity conductors 120a. Each of the second-voltage outlets 160b is connected to one of the second-polarity conductors 120b. The ground outlet 170 is connected to the ground conductor 140. A power source (not shown) can be connected to the inlet 180 to apply a first-voltage provided by the power source to the first-voltage outlets 160a and a second-voltage provided by the power source to the second-voltage outlets 160b. A second connector 190 is provided at a second end of the cable. The second connector 190 can connect the cable to an electrical vehicle for charging the electrical vehicle.

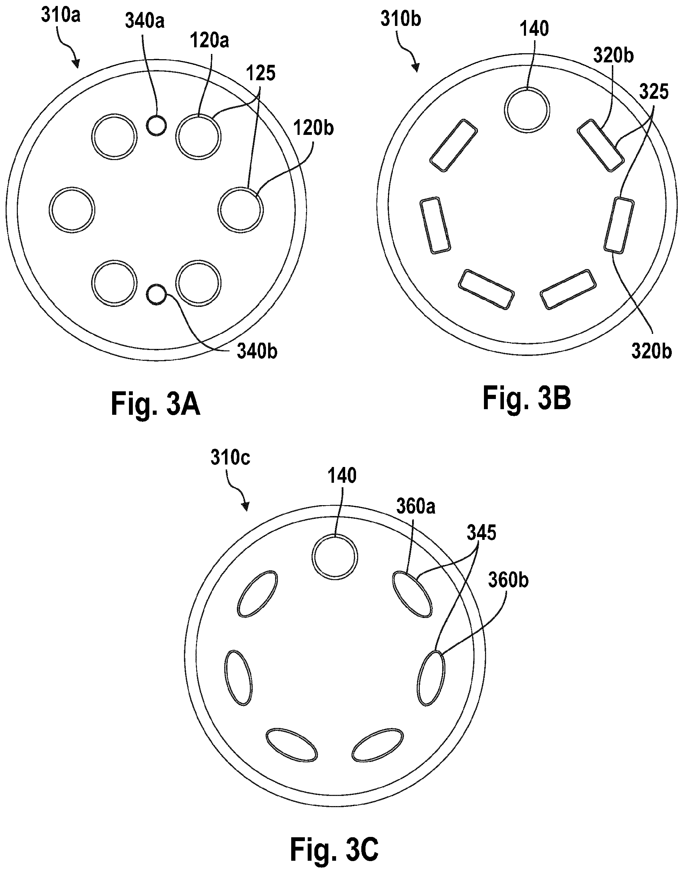

Figs. 3A - 3B show a schematic sectional view of cables 310a, 310b and 310c according to embodiments described herein. Cables 310a, 310b and 310c comprise alternative shapes and arrangements of conductors in the cable.

Fig. 3A shows a schematic sectional view of cable 310a. Cable 310a is similar to cable 110 shown in Fig. 1. Cable 310a comprises three first-polarity conductors 120a and three second-polarity conductors 120b which are arranged circumferentially around a geometrical center of the cable. The first-polarity conductors 120a and the second-polarity conductors 120b are arranged in an interleaved arrangement. First-polarity conductors 120a have second-polarity conductors 120b as next neighbors in the circumferential arrangement and vice versa. The cable 310a comprises a first ground conductor 340a and a second ground conductor 340b. The first ground conductor 340a and the second ground conductor 340b are each arranged between a first-polarity conductor 120a and a second-polarity conductor 120b. The first ground conductor 340a and the second ground conductor 340b are arranged diametrically opposite in the circumferential arrangement. The cable 310a has a two-fold rotational symmetry. That is, rotation of the cable 310a of 180° around an axis perpendicular to the paper plane will result in the same cross-sectional shape.

Fig. 3B shows a schematic sectional view of cable 310b. Cable 310b is similar to cable 110 shown in Fig. 1. Cable 310b comprises three first-polarity conductors 320a and three second-polarity conductors 320b which are arranged circumferentially around a geometrical center of the cable. The first-polarity conductors 320a and the second-polarity conductors 320b are arranged in an interleaved arrangement. The ground conductor 140 is placed between a first-polarity conductor and a second-polarity conductor in the circumferential arrangement. The first-polarity conductors 320a have a cross-sectional shape of a rectangle with curved edges. The second-polarity conductors 320b have a cross-sectional shape of a rectangle with curved edges. The first-polarity conductors 320a and the second-polarity conductors 320b can have alternative rectangular shapes having different height and width proportions and curved or flattened edges. The first-polarity conductors 320a and the second-polarity conductors 320b are provided with a dielectric insulation 325.

Fig. 3C shows a schematic sectional view of cable 310c. Cable 310c is similar to cable 110 shown in Fig. 1. Cable 310c comprises three first-polarity conductor 360a, three second-polarity conductor 360b and a ground conductor 140 which are arranged circumferentially around a geometrical center of the cable. The first-polarity conductors 360a have an elliptical cross-sectional shape. The second-polarity conductors 360b have an elliptical cross-sectional shape. The first-polarity conductors 360a and the second-polarity conductors 360b can have alternative elliptical shapes having different proportions of minor axis and major axis. The first-polarity conductors 360a and the second-polarity conductors 360b are arranged with the major axis in circumferential direction and the minor axis in radial direction. Alternatively, the first-polarity conductors and the second-polarity conductors can be placed with the major axis in radial direction and the minor axis in circumferential direction. The first-polarity conductors and the second-polarity conductors can be placed with the major axis (and minor axis) in any suitable direction. The first-polarity conductors 360a and the second-polarity conductors 360b are provided with a dielectric insulation 365.

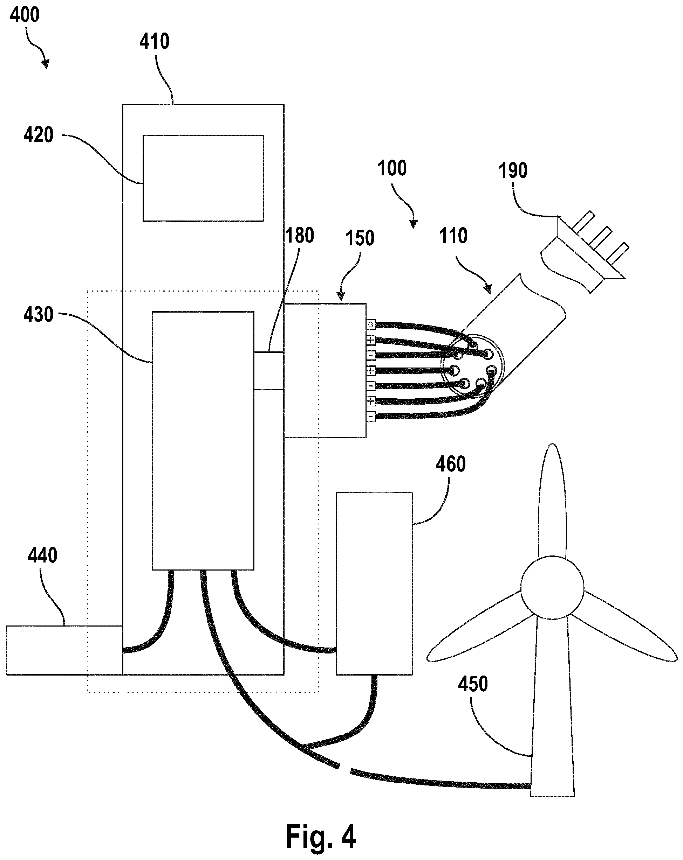

Fig. 4 shows a schematic view of a DC charging system for charging an electrical vehicle 400. The charging system 400 comprises a charging station body 410 and a DC charging cable assembly 100. The charging station body 410 comprises a user interface 420. A user can interact with the user interface 420 to set parameters for charging an electric vehicle. The user may set charging duration, total charging energy, charging power, charging voltage and/or charging current and/or any other parameter for charging an electrical vehicle. The dotted square in Fig. 4 indicates that the internal arrangement of the charging station body 410 is shown. The charging station body 410 comprises a power source 430. A first connector 150 of the charging cable assembly 100 is connected to the power source 430. An inlet 180 connects the first connector 150 to the power source. The connector 150 is configured to connect the cable 110 to the power source. The connector 150 is configured to connect each of the plurality of first-polarity conductors to a first voltage provided by the power source. The connector 150 is configured to connect each of the plurality of second-polarity conductors to a second voltage provided by the power source. The connector 150 is configured to connect the ground conductor to a ground contact of the power source. The cable 110 can comprise a second connector 190 configured to connect the cable to an electrical vehicle for charging the electrical vehicle. Through the first connector 150, the cable 110 and the second connector 190 the power source 430 can be connected to an electrical vehicle for charging the electrical vehicle.

The charging system 400 comprises a grid connection 440. The power source is connected to the gird connection 440. The grid can provide an electrical power to the power source 430. The charging system 400 comprises a renewable energy source 450. The power source 430 is connected to the renewable energy source 450. The renewable energy source 450 can provide an electrical power to the power source 430. The renewable energy source 450 can be any kind of renewable energy source. For example, the renewable energy source 450 can be a photovoltaic energy source, a wind turbine, a geothermal energy source, a bioenergy energy source or a hydropower energy source. The charging system 400 comprises a battery module 460. The power source 430 is connected to the battery module 460. The battery module can provide an electrical power to the power source 430. The renewable energy source 450 is connected to the battery module 460. The renewable energy source 450 can charged the battery module 460.

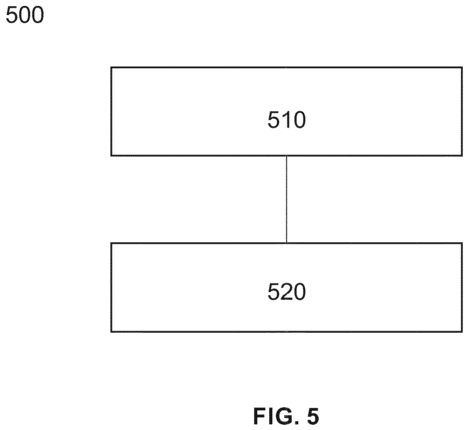

Fig. 5 shows a flow diagram illustrating a method 500 of charging an electric vehicle with a DC charging cable assembly according to embodiments described herein. At step 510 a first-polarity voltage is applied to the first-polarity conductors and a second-polarity voltage is applied to the second polarity conductors. At step 520 an electric vehicle is charged.

Step 510 can comprise connecting the first-polarity conductors to a first outlet of the power source configured to provide a first-polarity voltage; and connecting the second-polarity conductors to a second outlet of the power source configured to provide a second-polarity voltage.

Step 520 can comprise connecting the cable to the electrical vehicle with a second connector, wherein: the second connector is provided at a second end of the cable, and the second connector is configured to connect the cable to an electrical vehicle for charging the electrical vehicle.

### REFERENCE NUMBERS

- 100:: Charging cable assembly
- 110:: Cable
- 120a:: First-polarity conductor
- 120b:: Second-polarity conductor
- 125:: Insulation
- 130:: Magnetic Shielding
- 140:: Ground conductor
- 145:: filler material
- 150:: First Connector
- 155:: Housing
- 160a:: First-polarity outlet
- 160b:: Second-polarity outlet
- 170:: Ground Outlet
- 180:: Inlet
- 190:: Second Connector
- 310a:: Cable
- 310b:: Cable
- 310c:: Cable
- 320a:: First-polarity conductor
- 320b:: Second-polarity conductor
- 325:: Insulation
- 340a:: First ground conductor
- 340b:: Second ground conductor
- 360a:: First-polarity conductor
- 360b:: Second-polarity conductor
- 365:: Insulation
- 400:: Charging System
- 410:: Charging station body
- 420:: User interface
- 430:: Power source
- 440:: Grid connection
- 450:: Renewable energy source
- 460:: Battery module

## Claims

1. A DC charging cable assembly (100) for charging an electrical vehicle, the charging cable assembly comprising:
a cable (110, 310a, 310b, 310c), comprising:
a plurality of first-polarity conductors (120a, 320a, 360a);
a plurality of second-polarity conductors (120b, 320b, 360b); and
a magnetic shielding (130), wherein the magnetic shielding (130) is provided by a dispersion of magnetic shielding material provided in an external polymeric insulation of the cable,
wherein, in a cross-section of the cable (110, 310a, 310b, 310c), the first-polarity conductors (120a, 320a, 360a) and the second-polarity conductors (120b, 320b, 360b) are arranged circumferentially in an interleaved arrangement, and wherein the magnetic shielding (130) radially surrounds the interleaved arrangement of the first-polarity conductors (120a, 320a, 360a) and the second-polarity conductors (120b, 320b, 360b);
a first connector (150) at a first end of the cable (110, 310a, 310b, 310c) configured to connect the cable to a power source, the first connector (150) being configured for connecting the first-polarity conductors (120a, 320a, 360a) to a first-polarity voltage and connecting the second-polarity conductors (120b, 320b, 360b) to a second-polarity voltage.

2. The DC charging cable assembly (100) according to claim 1, comprising, for each of the first-polarity conductor (120a, 320a, 360a) and each of the second-polarity conductor (120b, 320b, 360b), a dielectric insulation (125, 325, 345) surrounding the respective conductor, wherein the dielectric insulation has a breakdown strength of at least 1 kV/mm.

3. The DC charging cable assembly according to claim 2, wherein the dielectric insulation (125, 325, 345) has a radial thickness of at least 0.1 mm.

4. The DC charging cable assembly according to any one of claims 1 through 3, wherein the magnetic shielding (130) is made of µ-metal and has a thickness of 0.05 mm to 2 mm, particularly a thickness of 0.05 mm to 1 mm.

5. The DC charging cable assembly (100) according to any one of claims 1 through 4, the cable (110, 310a, 310b, 310c) further comprising a first ground conductor (140, 340a, 340b), wherein:
the first ground conductor (140, 340a, 340b) extends from the first end of the cable to a second end of the cable.

6. The DC charging cable assembly (100) according to any one of claims 1 through 5, wherein the first-polarity conductors (120a, 360a) and the second-polarity conductors (120b, 360b) have a cross-sectional shape of an ellipse, preferably of a circle.

7. The DC charging cable assembly (100) according to any one of claims 1 through 5, wherein the first-polarity conductors (320a) and the second-polarity conductors (320b) have a cross sectional shape of a rectangle with curved edges or a cross sectional shape of a rectangle with flattened edges.

8. The DC charging cable assembly (100) according to any one of claims 1 through 7, comprising:
a second connector (190) at a second end of the cable configured to connect the cable (110, 310a, 310b, 310c) to an electrical vehicle for charging the electrical vehicle.

9. A DC charging system (400) for charging an electrical vehicle comprising:
a DC charging cable assembly (100) according to any one of claims 1 through 8; and
a charging station body (410),
wherein the charging station body (410) comprises a power source (430) configured to provide the first-polarity voltage and the second-polarity voltage, the power source (430) being connected to the first connector (150) of the DC charging cable assembly (100).

10. A method of charging an electrical vehicle with a DC charging cable assembly (100) according to any one of claims 1 through 8, the method comprising:
applying a first-polarity voltage to the first-polarity conductors (120a, 320a, 360a);
applying a second polarity voltage to the second-polarity conductors (120b, 320b, 360b); and
charging the electrical vehicle.

11. The method of claim 10, wherein the first-polarity voltage and the second-polarity voltage is provided by a charging station comprising a power source (430) and the method comprises:
connecting the first-polarity conductors (120a, 320a, 360a) to a first outlet of the power source (430) configured to provide a first-polarity voltage; and
connecting the second-polarity conductors (120b, 320b, 360b) to a second outlet of the power source (430) configured to provide a second-polarity voltage.

12. The method of any one of claims 10 through 11, comprising:
connecting the cable (110, 310a, 310b, 310c) to the electrical vehicle with a second connector (190), wherein:
the second connector (190) is provided at a second end of the cable (110, 310a, 310b, 310c), and
the second connector (190) is configured to connect the cable (110, 310a, 310b, 310c) to an electrical vehicle for charging the electrical vehicle.

13. The method of any one of claims 10 through 12, wherein a voltage difference between the first-polarity voltage and the second-polarity voltage is 0.2 - 2 kV or wherein the total current trough the plurality of first-polarity-conductors is 0.25 - 3 kA, particularly 1 - 3kA.

14. The method of any one of claims 10 through 13, wherein the charging the electric vehicle is with a power of 0.4 - 5 MW.

## Patentansprüche

1. Gleichstromladekabelanordnung (100) zum Laden eines Elektrofahrzeugs, wobei die Ladekabelanordnung Folgendes umfasst:
ein Kabel (110, 310a, 310b, 310c), das Folgendes umfasst:
eine Vielzahl von Leitern erster Polarität (120a, 320a, 360a);
eine Vielzahl von Leitern zweiter Polarität (120b, 320b, 360b); und
eine magnetische Abschirmung (130), wobei die magnetische Abschirmung (130) durch eine Dispersion eines magnetischen Abschirmungsmaterials bereitgestellt wird, das in einer externen polymeren Isolation des Kabels bereitgestellt ist,
wobei in einem Querschnitt des Kabels (110, 310a, 310b, 310c) die Leiter erster Polarität (120a, 320a, 360a) und die Leiter zweiter Polarität (120b, 320b, 360b) umlaufend in einer verschachtelten Anordnung angeordnet sind und wobei die magnetische Abschirmung (130) die verschachtelte Anordnung der Leiter erster Polarität (120a, 320b, 360a) und der Leiter zweiter Polarität (120), 320b) radial umgibt;
einen ersten Verbinder (150) an einem ersten Ende des Kabels (110, 310a, 310b, 310c), der dazu ausgelegt ist, das Kabel mit einer Leistungsquelle zu verbinden, wobei der erste Verbinder (150) dazu ausgelegt ist, die Leiter erster Polarität (120a, 320a, 360a) mit einer Spannung erster Polarität zu verbinden und die Leiter zweiter Polarität (120b, 320b, 360b) mit einer Spannung zweiter Polarität zu verbinden.

2. Gleichstromladekabelanordnung (100) nach Anspruch 1, die für sowohl den Leiter erster Polarität (120a, 320a, 360a) als auch den Leiter zweiter Polarität (120b, 320b, 360b) eine dielektrische Isolierung (125, 325, 345) umfasst, die den jeweiligen Leiter umgibt, wobei die dielektrische Isolierung eine Durchbruchfestigkeit von mindestens 1 kV/mm aufweist.

3. Gleichstromladekabelanordnung nach Anspruch 2, wobei die dielektrische Isolierung (125, 325, 345) eine radiale Dicke von mindestens 0,1 mm aufweist.

4. Gleichstromladekabelanordnung nach einem der Ansprüche 1 bis 3, wobei die magnetische Abschirmung (130) aus µ-Metall hergestellt ist und eine Dicke von 0,05 mm bis 2 mm, insbesondere eine Dicke von 0,05 mm bis 1 mm, aufweist.

5. Gleichstromladekabelanordnung (100) nach einem der Ansprüche 1 bis 4, wobei das Kabel (110, 310a, 310b, 310c) ferner einen ersten Masseleiter (140, 340a, 340b) umfasst, wobei:
sich der erste Masseleiter (140, 340a, 340b) vom ersten Ende des Kabels zu einem zweiten Ende des Kabels erstreckt.

6. Gleichstromladekabelanordnung (100) nach einem der Ansprüche 1 bis 5, wobei die Leiter erster Polarität (120a, 360a) und die Leiter zweiter Polarität (120b, 360b) eine Querschnittsform einer Ellipse, vorzugsweise eines Kreises, aufweisen.

7. Gleichstromladekabelanordnung (100) nach einem der Ansprüche 1 bis 5, wobei die Leiter erster Polarität (320a) und die Leiter zweiter Polarität (320b) eine Querschnittsform eines Rechtecks mit gekrümmten Kanten oder eine Querschnittsform eines Rechtecks mit abgeflachten Kanten aufweisen.

8. Gleichstromladekabelanordnung (100) nach einem der Ansprüche 1 bis 7, die Folgendes umfasst:
einen zweiten Verbinder (190) an einem zweiten Ende des Kabels, der dazu ausgelegt ist, das Kabel (110, 310a, 310b, 310c) mit einem Elektrofahrzeug zum Laden des Elektrofahrzeugs zu verbinden.

9. Gleichstromladesystem (400) zum Laden eines Elektrofahrzeugs, das Folgendes umfasst:
eine Gleichstromladekabelanordnung (100) nach einem der Ansprüche 1 bis 8; und
einen Ladestationskörper (410),
wobei der Ladestationskörper (410) eine Leistungsquelle (430) umfasst, die dazu ausgelegt ist, die Spannung erster Polarität und die Spannung zweiter Polarität bereitzustellen, wobei die Leistungsquelle (430) mit dem ersten Verbinder (150) der Gleichstromladekabelanordnung (100) verbunden ist.

10. Verfahren zum Laden eines Elektrofahrzeugs mit einer Gleichstromladekabelanordnung (100) nach einem der Ansprüche 1 bis 8, wobei das Verfahren Folgendes umfasst:
Anlegen einer Spannung erster Polarität an die Leiter erster Polarität (120a, 320a, 360a);
Anlegen einer Spannung zweiter Polarität an die Leiter zweiter Polarität (120b, 320b, 360b); und
Laden des Elektrofahrzeugs.

11. Verfahren nach Anspruch 10, wobei die Spannung erster Polarität und die Spannung zweiter Polarität durch eine Ladestation bereitgestellt werden, die eine Leistungsquelle (430) umfasst, und das Verfahren Folgendes umfasst:
Verbinden der Leiter erster Polarität (120a, 320a, 360a) mit einem ersten Ausgang der Leistungsquelle (430), die dazu ausgelegt ist, eine Spannung erster Polarität bereitzustellen; und
Verbinden der Leiter zweiter Polarität (120b, 320b, 360b) mit einem zweiten Ausgang der Leistungsquelle (430), der dazu ausgelegt ist, eine Spannung zweiter Polarität bereitzustellen.

12. Verfahren nach einem der Ansprüche 10 bis 11, das Folgendes umfasst:
Verbinden des Kabels (110, 310a, 310b, 310c) mit dem Elektrofahrzeug mit einem zweiten Verbinder (190), wobei: der zweite Verbinder (190) an einem zweiten Ende des Kabels (110, 310a, 310b, 310c) bereitgestellt ist, und
der zweite Verbinder (190) dazu ausgelegt ist, das Kabel (110, 310a, 310b, 310c) zum Laden des Elektrofahrzeugs mit einem Elektrofahrzeug zu verbinden.

13. Verfahren nach einem der Ansprüche 10 bis 12, wobei eine Spannungsdifferenz zwischen der Spannung erster Polarität und der Spannung zweiter Polarität 0,2 - 2 kV beträgt oder wobei der Gesamtstrom durch die mehreren Leiter erster Polarität 0,25 - 3 kA, insbesondere 1 - 3 kA beträgt.

14. Verfahren nach einem der Ansprüche 10 bis 13, wobei das Laden des Elektrofahrzeugs mit einer Leistung von 0,4 - 5 MW erfolgt.

## Revendications

1. Ensemble câble de charge CC (100) pour charger un véhicule électrique, l'ensemble câble de charge comprenant :
un câble (110, 310a, 310b, 310c), comprenant :
une pluralité de conducteurs de première polarité (120a, 320a, 360a) ;
une pluralité de conducteurs de seconde polarité (120b, 320b, 360b) ; et
un blindage magnétique (130), dans lequel le blindage magnétique (130) est fourni par une dispersion de matériau de blindage magnétique fourni dans une isolation polymère externe du câble,
dans lequel, dans une section transversale du câble (110, 310a, 310b, 310c), les conducteurs de première polarité (120a, 320a, 360a) et les conducteurs de seconde polarité (120b, 320b, 360b) sont agencés circonférentiellement selon un agencement entrelacé, et dans lequel le blindage magnétique (130) entoure radialement l'agencement entrelacé des conducteurs de première polarité (120a, 320a, 360a) et des conducteurs de seconde polarité (120b, 320b, 360b) ;
un premier connecteur (150) au niveau d'une première extrémité du câble (110, 310a, 310b, 310c) configuré pour connecter le câble à une source d'alimentation, le premier connecteur (150) étant configuré pour connecter les conducteurs de première polarité (120a, 320a, 360a) à une tension de première polarité et connecter les conducteurs de seconde polarité (120b, 320b, 360b) à une tension de seconde polarité.

2. Ensemble câble de charge CC (100) selon la revendication 1, comprenant, pour chacun du conducteur de première polarité (120a, 320a, 360a) et chacun du conducteur de seconde polarité (120b, 320b, 360b), une isolation diélectrique (125, 325, 345) entourant le conducteur respectif, dans lequel l'isolation diélectrique a une résistance à la rupture d'au moins 1 kV/mm.

3. Ensemble câble de charge CC selon la revendication 2, dans lequel l'isolation diélectrique (125, 325, 345) a une épaisseur radiale d'au moins 0,1 mm.

4. Ensemble câble de charge CC selon l'une quelconque des revendications 1 à 3, dans lequel le blindage magnétique (130) est constitué de métal µ et a une épaisseur de 0,05 mm à 2 mm, en particulier une épaisseur de 0,05 mm à 1 mm.

5. Ensemble câble de charge CC (100) selon l'une quelconque des revendications 1 à 4, le câble (110, 310a, 310b, 310c) comprenant en outre un premier conducteur de masse (140, 340a, 340b), dans lequel :
le premier conducteur de masse (140, 340a, 340b) s'étend de la première extrémité du câble à une seconde extrémité du câble.

6. Ensemble câble de charge CC (100) selon l'une quelconque des revendications 1 à 5, dans lequel les conducteurs de première polarité (120a, 360a) et les conducteurs de seconde polarité (120b, 360b) ont une forme en coupe transversale d'ellipse, de préférence de cercle.

7. Ensemble câble de charge CC (100) selon l'une quelconque des revendications 1 à 5, dans lequel les conducteurs de première polarité (320a) et les conducteurs de seconde polarité (320b) ont une forme en coupe transversale de rectangle avec des bords incurvés ou une forme en coupe transversale de rectangle avec des bords aplatis.

8. Ensemble câble de charge CC (100) selon l'une quelconque des revendications 1 à 7, comprenant :
un second connecteur (190) au niveau d'une seconde extrémité du câble configuré pour connecter le câble (110, 310a, 310b, 310c) à un véhicule électrique pour charger le véhicule électrique.

9. Câble de charge CC (400) pour charger un véhicule électrique, comprenant :
un ensemble câble de charge CC (100) selon l'une quelconque des revendications 1 à 8 ; et
un corps de station de charge (410),
dans lequel le corps de station de charge (410) comprend une source d'alimentation (430) configurée pour fournir la tension de première polarité et la tension de seconde polarité, la source d'alimentation (430) étant connectée au premier connecteur (150) de l'ensemble câble de charge CC (100).

10. Procédé de charge d'un véhicule électrique avec un ensemble câble de charge CC (100) selon l'une quelconque des revendications 1 à 8, le procédé comprenant :
l'application d'une tension de première polarité aux conducteurs de première polarité (120a, 320a, 360a) ;
l'application d'une tension de seconde polarité aux conducteurs de seconde polarité (120b, 320b, 360b) ; et
la charge du véhicule électrique.

11. Procédé selon la revendication 10, dans lequel la tension de première polarité et la tension de seconde polarité sont fournies par une station de charge comprenant une source d'alimentation (430) et le procédé comprend :
la connexion des conducteurs de première polarité (120a, 320a, 360a) à une première sortie de la source d'alimentation (430) configurée pour fournir une tension de première polarité, et
la connexion des conducteurs de seconde polarité (120b, 320b, 360b) à une seconde sortie de la source d'alimentation (430) configurée pour fournir une tension de seconde polarité.

12. Procédé selon l'une quelconque des revendications 10 à 11, comprenant :
la connexion du câble (110, 310a, 310b, 310c) au véhicule électrique avec un second connecteur (190), dans lequel :
le second connecteur (190) est fourni au niveau d'une seconde extrémité du câble (110, 310a, 310b, 310c), et
le second connecteur (190) est configuré pour connecter le câble (110, 310a, 310b, 310c) à un véhicule électrique pour charger le véhicule électrique.

13. Procédé selon l'une quelconque des revendications 10 à 12, dans lequel une différence de tension entre la tension de première polarité et la tension de seconde polarité est de 0,2 à 2 kV ou dans lequel le courant total traversant la pluralité de conducteurs de première polarité est de 0,25 à 3 kA, en particulier de 1 à 3 kA.

14. Procédé selon l'une quelconque des revendications 10 à 13, dans lequel la charge du véhicule électrique est réalisée avec une puissance de 0,4 à 5 MW.
